# EUROPEAN PATENT APPLICATION

(11) **EP 4 502 872 A1**
(43) Date of publication of application: **05.02.2025**
(21) Application number: 23858767.9
(22) Date of filing: 01.06.2023
(51) Int. Cl.: G06N 10/20

(54) **WAVEFORM DATA TRANSMISSION METHOD AND SYSTEM, AND STORAGE MEDIUM**

(30) Priority: 01.09.2022 CN 202211067582
(71) Applicant: Tencent Technology (Shenzhen) Company Limited, Shenzhen, Guangdong 518057 (CN)
(72) Inventor: YU, Qiaonian, Shenzhen, Guangdong 518057 (CN); ZHANG, Zhenxing, Shenzhen, Guangdong 518057 (CN); XU, Xiong, Shenzhen, Guangdong 518057 (CN); ZHANG, Shengyu, Shenzhen, Guangdong 518057 (CN)
(74) Representative: Reddie & Grose LLP
(86) International application number: PCT/CN2023/097698
(87) International publication number: WO 2024/045728

(57) **Abstract**

A waveform data transmission method and system, and a storage medium, relating to the technical field of quanta. The method comprises: measurement and control software generates measurement and control waveform data, compresses the measurement and control waveform data to obtain compressed data, and transmits the compressed data to an electronics system, wherein the measurement and control waveform data is data of a first signal waveform represented in the form of a digital signal and used for measuring and controlling a quantum chip (210); and the electronics system decompresses the received compressed data to obtain recovered measurement and control waveform data, and transmits the first signal waveform to the quantum chip according to the recovered measurement and control waveform data, wherein the first signal waveform is used for measuring and controlling the quantum chip (220). The measurement and control waveform data is compressed and then transmitted, thereby reducing the time consumption of the measurement and control waveform data in the transmission process, and reducing the overall time consumption of quantum bit measurement and control experiments.

## Description

### RELATED APPLICATION

This application claims priority to Chinese Patent Application No. 202211067582.6, filed with the Chinese Patent Office on September 01, 2022 and entitled "WAVEFORM TRANSMISSION METHOD FOR QUBIT control and measurement SYSTEM, SYSTEM, AND STORAGE MEDIUM".

### FIELD OF THE TECHNOLOGY

The embodiments of this application relate to the field of quantum technologies, and in particular, to a waveform data transmission method, a system, and a storage medium.

### BACKGROUND OF THE DISCLOSURE

Before using a quantum chip, it is necessary to standardize and calibrate a signal for controlling the quantum chip. In the process of standardization and calibration, it is usually necessary to perform a plurality of times of qubit measurement experiments.

For one qubit measurement experiment, a user transmits defined waveform data to an electronics system by using control and measurement software, and the electronics system converts the waveform data into a corresponding signal waveform and transmits the signal waveform to the quantum chip. Therefore, in the process of the qubit measurement experiment, the waveform data needs to be circulated in a plurality of modules of the control and measurement software and the electronics system.

### SUMMARY

The embodiments of this application provide a waveform data transmission method, a system, and a storage medium, to reduce the time consumption of a qubit measurement experiment. The technical solutions are as follows:
An aspect of the embodiments of this application provides a waveform data transmission method, performed by a qubit control and measurement system, and the qubit control and measurement system including: control and measurement software, an electronics system, and a quantum chip. The method includes the following steps:
generating, by the control and measurement software, control and measurement waveform data, the control and measurement waveform data being data of a first signal waveform for control and measurement of the quantum chip, the first signal waveform being represented by a digital signal;
compressing, by the control and measurement software, the control and measurement waveform data to obtain compressed data, and transmitting, by the control and measurement software, the compressed data to the electronics system; and
decompressing, by the electronics system, the received compressed data to obtain recovered control and measurement waveform data, and transmitting, by the control and measurement software, the first signal waveform to the quantum chip according to the recovered control and measurement waveform data.

An aspect of the embodiments of this application provides a qubit control and measurement system, the qubit control and measurement system including: control and measurement software, an electronics system, and a quantum chip; and
the control and measurement software being configured to generate control and measurement waveform data, compress the control and measurement waveform data to obtain compressed data, and transmit the compressed data to the electronics system, the control and measurement waveform data being data of a first signal waveform for control and measurement of the quantum chip, the first signal waveform being represented by a digital signal; and
the electronics system being configured to decompress the received compressed data to obtain recovered control and measurement waveform data, and transmit the first signal waveform to the quantum chip according to the recovered control and measurement waveform data.

An aspect of the embodiments of this application provides a computer device, including a processor and a memory, storing a computer program, and the computer program being loaded and executed by the processor to implement the foregoing waveform data transmission method.

An aspect of the embodiments of this application provides a non-volatile computer-readable storage medium, storing a computer program, and the computer program being loaded and executed by a processor to implement the foregoing waveform data transmission method.

An aspect of the embodiments of this application provides a computer program product, the computer program product including a computer program, stored in a computer-readable storage medium. A processor of the computer device reads the computer program from the computer-readable storage medium, and the processor executes the computer program, so that the computer device executes the foregoing waveform data transmission method.

Another aspect of the embodiments of this application provides a computer program, including computer instructions, the computer instructions being loaded and executed by a processor, so that the computer implements any one of the foregoing waveform data transmission methods.

By first compressing the control and measurement waveform data and then transmitting the compressed control and measurement waveform data, the time consumption of the control and measurement waveform data in the transmission process is reduced. In the process of standardization and calibration of the signal, that is, the qubit, for controlling the quantum chip, usually a plurality of times of (10K to 100K) qubit measurement experiments need to be performed, and one qubit needs to be measured 1K to 10K times in each qubit measurement experiment, so that the time consumption after superposition of the plurality of times of qubit measurement experiments is greatly reduced.

### BRIEF DESCRIPTION OF THE DRAWINGS

FIG. 1 is a schematic diagram of an implementation environment according to an embodiment of this application.
FIG. 2 is a flowchart of a waveform data transmission method according to an embodiment of this application.
FIG. 3 is a flowchart of a waveform data transmission method according to another embodiment of this application.
FIG. 4 is a structural diagram of a qubit control and measurement system according to an embodiment of this application.
FIG. 5 is a structural diagram of a qubit control and measurement system according to another embodiment of this application.
FIG. 6 is a flowchart of a waveform data transmission method according to another embodiment of this application.
FIG. 7 is a structural diagram of a qubit control and measurement system according to another embodiment of this application.
FIG. 8 is a structural diagram of a qubit control and measurement system according to another embodiment of this application.
FIG. 9 is a structural diagram of a qubit control and measurement system according to another embodiment of this application.
FIG. 10 is a structural diagram of a computer device according to an embodiment of this application.

### DESCRIPTION OF EMBODIMENTS

To make the objectives, technical solutions, and advantages of this application clearer, the following further describes implementations of this application in detail with reference to the accompanying drawings.

Before the embodiments of this application are introduced and described, some terms related to this application are first explained and described.
1. Quantum computation (QC): a method for quickly completing a specific computational task by using the superposition and entanglement properties of quantum states.
2. Field programmable gate array (FPGA) chip: a product further developed on the basis of a programmable device, such as a programmable array logic (PAL) and a generic array logic (GAL). The FPGA chip presents as a semi-customized circuit in the field of application specific integrated circuits (ASICs), which not only overcomes the shortcomings of customized circuits, but also overcomes the shortcomings of the limited number of gate circuits of an original programmable device.
3. Advanced RISC machines (ARMs): a family of reduced instruction set (RISC) processor architectures, which is widely used in many embedded system designs.
4. Arbitrary waveform generator (AWG): the AWG receives waveform information configured by a digital signal, and generates a corresponding analog waveform through digital to analog conversion, and is configured to generate a waveform for controlling and reading a qubit in a quantum control and measurement system.
5. Digital acquisition (DAQ): the DAQ receives an analog signal input, obtains a corresponding digital signal through analog to digital conversion, uses the digital signal for various types of subsequent processing, and is configured to receive a reading result of a quantum chip in a quantum control and measurement system.
6. Quantum control processor (QCP): a module for executing quantum instructions, for receiving a result from a DAQ in an experiment process and controlling an AWG to transmit a waveform corresponding to a quantum operation. In a quantum control and measurement system, the QCP performs program flow control and feedback control by processing instructions generated by a quantum program in real time.
7. Quantum control & measurement system, also referred to as a qubit control and measurement system: a system for implementing execution of a quantum program by running a quantum instruction set, providing an input signal to a quantum chip for controlling, and measuring a quantum chip to acquire a result. In superconducting quantum computing, a set of quantum control and measurement system usually includes the foregoing AWG, DAQ, and QCP.
8. Digital to analog converter (DAC): a device for converting a digital signal into an analog signal.
9. Analog to digital converter (ADC): a device for converting an analog signal (for example, sound picked up by a microphone or light entering a digital camera) into a digital signal.
10. Ramsey experiment: for superconducting qubits, by using a Ramsey experiment, two important bit properties can be calibrated: a qubit frequency and a decoherence time.
11. Randomized benchmarking experiment: the randomized benchmarking experiment is a method for evaluating a capability of a quantum computing hardware platform by estimating an average error rate measured under randomized quantum gate operations that execute a long sequence.

In the related art, in the process of standardization and calibration of qubits, usually a plurality of times of (10K to 100K) experiments need to be performed, and one qubit needs to be measured 1K to 10K (thousand) times in each experiment, and waveform data in each experiment needs to be circulated in a plurality of modules of the control and measurement software and the electronics system. Therefore, the time consumption after superimposition of the plurality of measurement experiments is very large. In this regard, the embodiments of this application provide a waveform data transmission method, a system, and a storage medium.

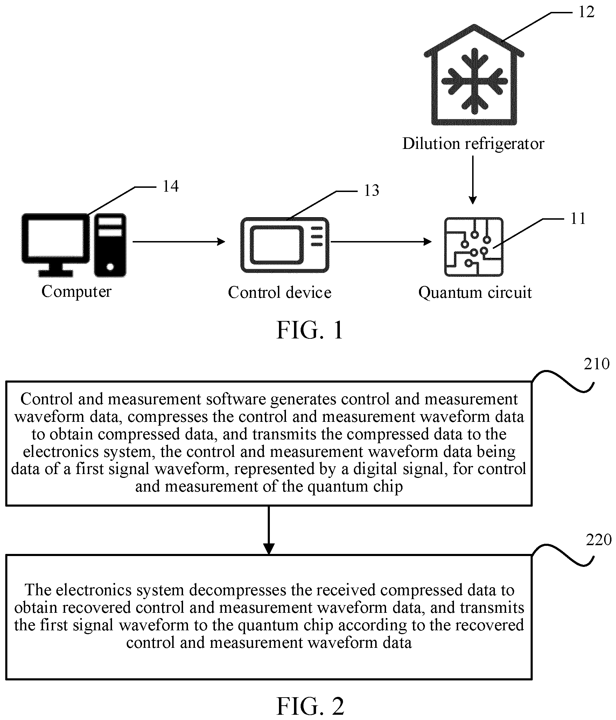

FIG. 1 is a schematic diagram of an implementation environment according to an embodiment of this application. As shown in FIG. 1, the implementation environment of the solution can be implemented as a superconducting quantum computing platform. The implementation environment of the solution may include: a quantum circuit 11, a dilution refrigerator 12, a control device 13, and a computer device 14.

The quantum circuit 11 is a circuit that acts on a physical qubit. The quantum circuit 11 may be implemented as a quantum chip, such as a superconducting quantum chip at a temperature near absolute zero. The dilution refrigerator 12 is configured to provide an absolute zero environment for the superconducting quantum chip.

The control device 13 is configured to control the quantum circuit 11. The computer device 14 is configured to control the control device 13. For example, a written quantum program (such as control and measurement software) is compiled by software in the computer device 14 into an instruction and transmitted to the control device 13 (such as an electronic/microwave control system). The control device 13 converts the instruction into an electronic/microwave control signal and inputs the electronic/microwave control signal to the dilution refrigerator 12, to control a superconducting qubit at a temperature less than 10 mK. A reading process is reversed. A read waveform is transmitted to the quantum circuit 11. The control device 13 reads the waveform from the quantum circuit 11 and then transmits the waveform to the computer device 14. In this embodiment of this application, the control device 13 may also be referred to as an electronics system.

FIG. 2 is a flowchart of a waveform data transmission method according to an embodiment of this application. The method may be applied to a qubit control and measurement system. In other words, the method is executed by the qubit control and measurement system. The qubit control and measurement system includes control and measurement software, an electronics system, and a quantum chip. The method includes at least one of the following steps 210 to 220:
Step 210: Control and measurement software generates control and measurement waveform data, compresses the control and measurement waveform data to obtain compressed data, and transmits the compressed data to the electronics system, the control and measurement waveform data being data of a first signal waveform, represented by a digital signal, for control and measurement of the quantum chip.

The control and measurement software refers to a set of software modules for processing the control and measurement waveform data. In one embodiment, as shown in FIG. 1, the control and measurement software is run on the computer device 14.

In one embodiment, the first signal waveform in this application may be a first analog signal waveform. In embodiments, the expression "signal waveform" may also be construed as a signal having a defined waveform (i.e., a signal), for example, having a waveform defined by the control and measurement waveform data. Accordingly, the first signal waveform may be alternatively termed as a first digital signal. In addition, the control and measurement waveform data may be customized by a user by using the control and measurement software. For example, the user customizes information such as an amplitude and a phase of the control and measurement waveform by using the control and measurement software, and the control and measurement software generates the control and measurement waveform data according to the information.

The electronics system is a set of hardware devices configured to process the control and measurement waveform data. In one embodiment, the electronics system may be disposed in one hardware device, or may be disposed in a plurality of hardware devices. This is not limited in this application. In one embodiment, the electronics system includes at least one of an electronic control device and a microwave control device.

The compression refers to reducing a data amount of the control and measurement waveform data by using a compression algorithm. In one embodiment, the compression algorithm may be an LZ4 compression algorithm, may be a GZip compression algorithm, or may be a Zlib compression algorithm. This is not limited in this application. For example, the control and measurement software compresses the control and measurement waveform data by using the LZ4 compression algorithm.

For example, the control and measurement software generates 1 megabits (MB) of sinusoidal control and measurement waveform data, compresses the control and measurement waveform data into 26 kilobytes (KB) of compressed data, and transmits the compressed data to the electronics system. In one embodiment, a compression ratio of the control and measurement waveform data may vary according to a format of the control and measurement waveform data.

In one embodiment, the control and measurement software calibrates the control and measurement waveform data, to obtain calibrated control and measurement waveform data; the control and measurement software compresses the calibrated control and measurement waveform data, to obtain first compressed waveform data; or the control and measurement software transmits the first compressed waveform data to the electronics system.

For example, the control and measurement software generates control and measurement waveform data 0111000001110000, and calibrates the control and measurement waveform data 0111000001110000, to obtain calibrated control and measurement waveform data 1111000011110000; then compresses the calibrated control and measurement waveform data 1111000011110000 to obtain first compressed waveform data; and subsequently transmits the first compressed waveform data to the electronics system. An example of the control and measurement waveform data in this specification is only for ease of understanding, and the specific format and the data amount of the control and measurement waveform data are not limited in this application.

Step 220: The electronics system decompresses the received compressed data to obtain recovered control and measurement waveform data, and transmits the first signal waveform to the quantum chip according to the recovered control and measurement waveform data.

The first signal waveform is used for measuring and controlling the quantum chip. Decompression refers to a reverse process of the compression, which is to recover the compressed control and measurement waveform data to the size before the compression.

For example, the electronics system receives 26-KB compressed data, decompresses the compressed data, to obtain 1-MB recovered control and measurement waveform data, and transmits the first signal waveform to the quantum chip according to the recovered control and measurement waveform data. In some embodiments, the first signal waveform is generated from the recovered control and measurement waveform data, and it is noted that those in the art can understand how to generate the first signal waveform from the corresponding waveform data.

In one embodiment, the electronics system decompresses the received first compressed waveform data, to obtain recovered calibrated control and measurement waveform data, and transmits the first signal waveform to the quantum chip according to the recovered calibrated control and measurement waveform data.

For example, the electronics system receives 26-KB first compressed waveform data, decompresses the first compressed waveform data, to obtain 1-MB of recovered calibrated control and measurement waveform data, and transmits the first signal waveform to the quantum chip according to the recovered calibrated control and measurement waveform data.

According to the technical solution provided in this embodiment of this application, the control and measurement waveform data is compressed and transmitted, thereby reducing the time consumption of control and measurement waveform data in the transmission process. In the process of standardization and calibration of a qubit, usually a plurality of times of (10K to 100K) qubit measurement experiments need to be performed, and one qubit needs to be measured 1K to 10K (thousand) times in each a qubit measurement experiment. Therefore, by using the technical solution of this application, the time consumption after superposition of the plurality of times of qubit measurement experiments is greatly reduced.

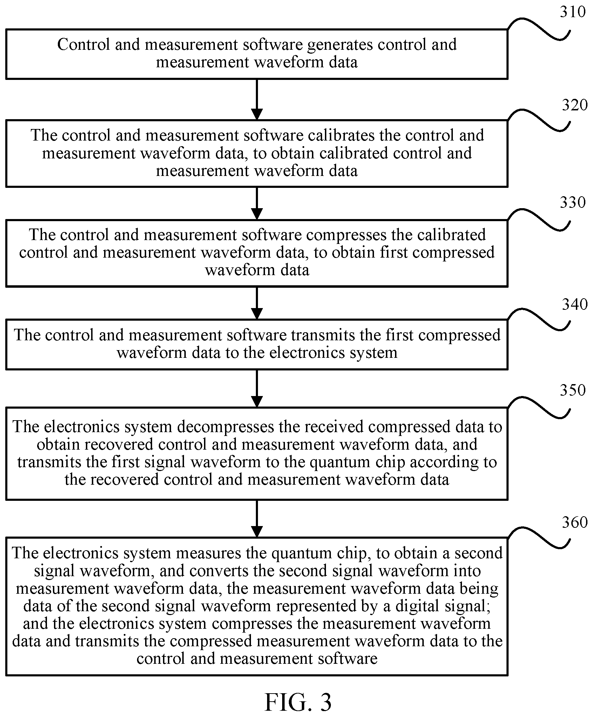

FIG. 3 is a flowchart of a waveform data transmission method according to another embodiment of this application. The method may be applied to a qubit control and measurement system. The method includes at least one of the following steps 310 to 360:
Step 310: Control and measurement software generates control and measurement waveform data.

For an implementation of step 310, related content of step 210 can be referred to, and details are not described herein again.

Step 320: The control and measurement software calibrates the control and measurement waveform data to obtain calibrated control and measurement waveform data.

In one embodiment, the control and measurement software obtains a calibration parameter of the control and measurement waveform data; calibrates the control and measurement waveform data according to the calibration parameter, to obtain the calibrated control and measurement waveform data.

The calibration parameter refers to a parameter for calibrating the control and measurement waveform data. In one embodiment, before the qubit control and measurement experiment, the control and measurement software obtains the calibration parameter. For example, the control and measurement software transmits test waveform data to the electronics system, and obtains the calibration parameter according to the test waveform data.

In one embodiment, the control and measurement software transmits defined test waveform data to the electronics system; the electronics system generates a signal waveform corresponding to the test waveform data; or the control and measurement software obtains actual waveform data obtained by measuring the signal waveform corresponding to the test waveform data, and determines the calibration parameter according to the test waveform data and the actual waveform data. For example, the signal waveform corresponding to the test waveform data may be an analog signal waveform.

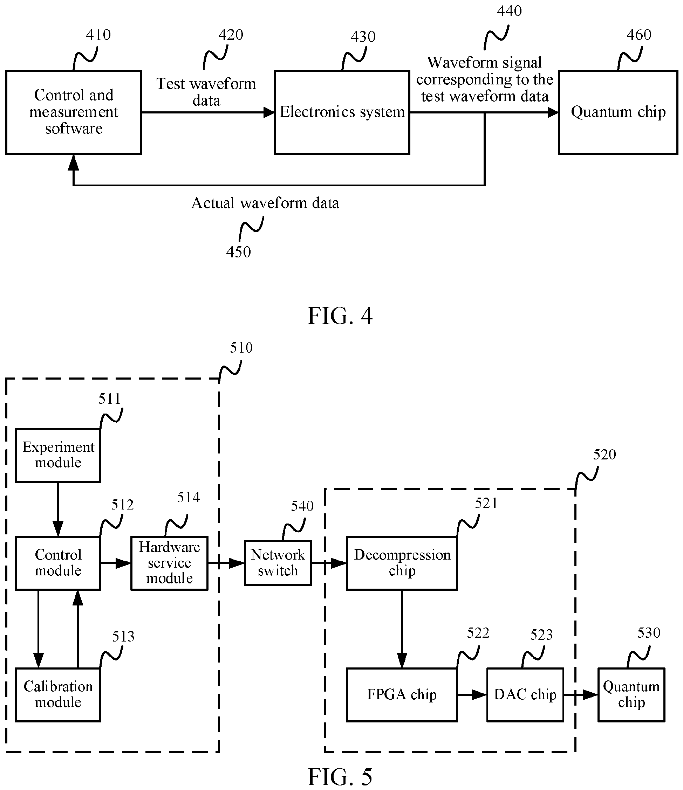

For example, as shown in FIG. 4, control and measurement software 410 transmits defined test waveform data 420 to an electronics system 430. The electronics system 430 generates a signal waveform 440 corresponding to the test waveform data, and transmits the signal waveform 440 to a quantum chip 460. The control and measurement software 410 obtains actual waveform data 450 obtained by measuring the signal waveform 440 corresponding to the test waveform data, and determines the calibration parameter according to the test waveform data 420 and the actual waveform data 450.

The control and measurement software calibrates the control and measurement waveform data according to the calibration parameter. In one embodiment, the control and measurement software calibrates the control and measurement waveform data according to the calibration parameter and a calibration function. In one embodiment, the calibration function is preset by the control and measurement software, and the calibration parameter is a parameter used in the calibration function. For example, the control and measurement software updates the calibration function according to the calibration parameter, and calibrates the control and measurement waveform data by using the calibration function, to obtain the calibrated control and measurement waveform data. An occasion for presetting the calibration function is not limited in this embodiment of this application, and may be preset before the control and measurement waveform data is calibrated.

By calibrating the control and measurement waveform data, the effective calibration parameter is obtained to ensure the accuracy of the qubit control and measurement experiment.

Step 330: The control and measurement software compresses the calibrated control and measurement waveform data, to obtain first compressed waveform data.

Compressing the calibrated control and measurement waveform data refers to reducing the data amount of the calibrated control and measurement waveform data by using a compression algorithm. In one embodiment, the compression algorithm may be an LZ4 compression algorithm, may be a GZip compression algorithm, or may be a Zlib compression algorithm. This is not limited in this application. For example, the control and measurement software compresses the calibrated control and measurement waveform data by using the LZ4 compression algorithm.

Step 340: The control and measurement software transmits the first compressed waveform data to the electronics system.

In one embodiment, the control and measurement software includes an experiment module, a control module, and a calibration module, and a hardware service module. In one embodiment, the control module may alternatively be referred to as a quantum controller in the embodiments of this application.

The experiment module is configured to implement human-computer interaction between the qubit control and measurement system and a user. For example, the user may customize the control and measurement waveform data by using the experiment module. The control module is equivalent to a central processing unit of the control and measurement software, is connected to the experiment module, the calibration module, and the hardware service module, and is configured to implement information exchange among the experiment module, the calibration module, and the hardware service module. The calibration module is configured to calibrate the control and measurement waveform data. The hardware service module is configured to implement interaction between the control and measurement software and the electronics system.

The experiment module is configured to generate the control and measurement waveform data, compress the control and measurement waveform data to obtain second compressed waveform data, and transmit the second compressed waveform data to the control module.

In one embodiment, the control and measurement waveform data is customized by a user by using the experiment module. For example, the user defines information such as an amplitude and a phase of the control and measurement waveform by using the experiment module, and the experiment module generates the control and measurement waveform data according to the information. For example, the user defines an amplitude A and a phase Φ of the control and measurement waveform by using the experiment module, and the experiment module generates the control and measurement waveform data according to the amplitude A and the phase Φ.

For example, the experiment module generates 1-MB sinusoidal control and measurement waveform data, compresses the control and measurement waveform data to obtain 26-KB of second compressed waveform data, and transmits the second compressed waveform data to the control module.

The control module is configured to transmit the second compressed waveform data to the calibration module.

The calibration module is configured to decompress the second compressed waveform data to obtain the control and measurement waveform data, calibrate the control and measurement waveform data to obtain the calibrated control and measurement waveform data, compress the calibrated control and measurement waveform data to obtain the first compressed waveform data, and transmit the first compressed waveform data to the control module.

For example, the calibration module decompresses the second compressed waveform data to obtain control and measurement waveform data 1111000011110000, calibrates the control and measurement waveform data to obtain calibrated control and measurement waveform data 1111100011111000, compresses the calibrated control and measurement waveform data to obtain first compressed waveform data, and transmits the first compressed waveform data to the control module.

The control module is further configured to transmit the first compressed waveform data to the hardware service module.

The hardware service module is configured to transmit the first compressed waveform data to the electronics system.

For example, as shown in FIG. 5, the control and measurement software 510 includes an experiment module 511, a control module 512, a calibration module 513, and a hardware service module 514. The control module 512 is equivalent to a main controller (a central processing unit), is connected to the experiment module 511, the calibration module 513, and the hardware service module 514, and is configured to implement interaction among the experiment module 511, the calibration module 513, and the hardware service module 514. The control module 512 may be connected to a plurality of experiment modules 511. For example, the control module 512 may be connected to an experiment module a and an experiment module b. Different experiment modules may invoke the control module 512 at different time.

The experiment module 511 generates control and measurement waveform data, compresses the control and measurement waveform data to obtain second compressed waveform data, and transmits the second compressed waveform data to the control module 512.

The control module 512 transmits the second compressed waveform data to the calibration module 513.

The calibration module 513 decompresses the second compressed waveform data to obtain the control and measurement waveform data, calibrates the control and measurement waveform data to obtain the calibrated control and measurement waveform data, compresses the calibrated control and measurement waveform data to obtain the first compressed waveform data, and transmits the first compressed waveform data to the control module 512.

The control module 512 transmits the first compressed waveform data to the hardware service module 514.

The hardware service module 514 transmits the first compressed waveform data to the electronics system 520.

In one embodiment, there is also a network switch between the control and measurement software and the electronics system. As shown in FIG. 5, the network switch 540 is a switch that is deployed in a network and is responsible for data relay transmission.

Step 350: The electronics system decompresses the received compressed data to obtain recovered control and measurement waveform data, and transmits the first signal waveform to the quantum chip according to the recovered control and measurement waveform data.

The first signal waveform is used for measuring and controlling the quantum chip. In one embodiment, the electronics system includes a processing chip and an FPGA chip.

The processing chip is configured to decompress and compress the waveform data. The FPGA chip is configured to adjust the waveform data according to requirements of different DAC chips on the waveform data.

The processing chip is configured to decompress the received compressed data to obtain recovered control and measurement waveform data, and transmit the recovered control and measurement waveform data to the FPGA chip.

In one embodiment, the processing chip may be an ARM chip. The ARM chip is configured to decompress the received compressed data to obtain recovered control and measurement waveform data, and transmit the recovered control and measurement waveform data to the FPGA chip.

For example, the processing chip receives 5-MB compressed data, decompresses the compressed data to obtain 10-MB recovered control and measurement waveform data, and transmits the recovered control and measurement waveform data to the FPGA chip.

In one embodiment, the processing chip decompresses the received first compressed waveform data to obtain recovered calibrated control and measurement waveform data, and transmits the recovered calibrated control and measurement waveform data to the FPGA chip.

The FPGA chip is configured to control a digital to analog converter DAC chip to generate the first signal waveform corresponding to the recovered control and measurement waveform data, and transmit the first signal waveform to the quantum chip.

In one embodiment, the FPGA chip adjusts a format of the recovered control and measurement waveform data according to a control signal, to obtain adjusted waveform data; the FPGA chip transmits the adjusted waveform data to the DAC chip; and the DAC chip generates the first signal waveform according to the adjusted waveform data, and transmits the first signal waveform to the quantum chip.

In one embodiment, the control signal is generated by the control and measurement software. For example, the experiment module generates a control signal. In one embodiment, the control signal may be automatically generated by the control and measurement software, or may be customized by a user by using the experiment module. This is not limited in this application.

In one embodiment, the control signal may be transmitted to the electronics system after being compressed by the control and measurement software, or may be directly transmitted to the electronics system by the control and measurement software. This is not limited in this application. In an example, the control and measurement software generates a control signal and transmits the control signal to the electronics system. In another example, the control and measurement software compresses the generated control signal and transmits the control signal to the electronics system.

In one embodiment, the control signal may be generated together with the control and measurement waveform data, or may not be generated together with the control and measurement waveform data. This is not limited in this application. In an example, the control and measurement software generates the control signal while generating the control and measurement waveform data. For example, a user defines both a control signal and a feature of the control and measurement waveform by using the experiment module. In another example, the control and measurement waveform data and the control signal are successively generated by the control and measurement software, and the time sequence in which the control and measurement waveform data and the control signal are generated is not limited in this application.

In one embodiment, in a process of transmitting the control signal, the control module may transmit the control signal to the hardware service module by using the calibration module, or directly without using the calibration module. This is not limited in this application. In an example, the control module transmits the control signal to the calibration module, and then the calibration module transmits the control signal transmitted back to the hardware service module. In another example, the control module transmits the control signal directly to the hardware service module.

The hardware device in the electronics system is controlled according to the control signal, so that the hardware device in the electronics system can be replaced according to the needs of the qubit control and measurement experiment, and can adapt to different types of hardware devices. In this embodiment of this application, the qubit control and measurement experiment is also referred to as a qubit measurement experiment.

For example, as shown in FIG. 5, the electronics system 520 includes a decompression chip 521 and an FPGA chip 522. The decompression chip 521 is also referred to as a processing chip.

The decompression chip 521 decompresses the received compressed data to obtain recovered control and measurement waveform data, and transmits the recovered control and measurement waveform data to the FPGA chip 522.

The FPGA chip 522 controls a digital to analog converter DAC chip 523 to generate a first signal waveform corresponding to the recovered control and measurement waveform data, and transmits the first signal waveform to the quantum chip 530.

In one embodiment, the FPGA chip 522 adjusts a format of the recovered control and measurement waveform data according to a control signal, to obtain the adjusted waveform data; the FPGA chip 522 transmits the adjusted waveform data to the DAC chip 523; or the DAC chip 523 generates the first signal waveform according to the adjusted waveform data, and transmits the first signal waveform to the quantum chip 530.

Step 360: The electronics system measures the quantum chip, to obtain a second signal waveform, and converts the second signal waveform into measurement waveform data, the measurement waveform data being data of the second signal waveform represented by a digital signal; and the electronics system compresses the measurement waveform data and transmits the compressed measurement waveform data to the control and measurement software.

In one embodiment, the electronics system measures the quantum chip to obtain a second signal waveform. In one embodiment, the electronics system further includes an ADC chip. The ADC chip converts the second signal waveform into measurement waveform data and transmits the measurement waveform data to the FPGA chip. The second signal waveform of this application may be a second analog signal waveform.

In one embodiment, the measurement waveform data may be compressed by an FPGA chip, or may be compressed by a processing chip, also referred to as a decompression chip. This is not limited in this application. In an example, the measurement waveform data is compressed by the FPGA chip, then the compressed measurement waveform data is transmitted to the processing chip, and subsequently the processing chip is transmitted to the control and measurement software. In another example, the FPGA chip transmits the measurement waveform data to the processing chip, and the processing chip compresses the measurement waveform data, and transmits the compressed measurement waveform data to the control and measurement software.

In one embodiment, the hardware service module receives the compressed measurement waveform data and transmits the compressed measurement waveform data to the control module; the control module transmits the compressed measurement waveform data to the calibration module; the calibration module decompresses the compressed measurement waveform data to obtain the measurement waveform data, calibrates the measurement waveform data to obtain the calibrated measurement waveform data, compresses the calibrated measurement waveform data to obtain third compressed waveform data (that is, the compressed and calibrated measurement waveform data), and transmits the third compressed waveform data to the control module; the control module transmits the third compressed waveform data to the experiment module; and the experiment module decompresses the third compressed waveform data to obtain the calibrated measurement waveform data.

The transmission of the measurement waveform data is also compressed, thereby further reducing the time consumption in the waveform data transmission process.

According to the technical solution provided in this embodiment of this application, an effective calibration parameter is obtained by calibrating the control and measurement waveform data and the measurement waveform data, thereby ensuring the accuracy of the qubit control and measurement experiment; and in addition, both the control and measurement waveform data and the measurement waveform data are transmitted in a compressed form, thereby reducing the time consumption of the control and measurement waveform data and the measurement waveform data in the transmission process. In the process of standardization and calibration of a qubit, usually a plurality of times of qubit measurement experiments need to be performed, and one qubit needs to be measured 1K to 10K (thousand) times in each a qubit measurement experiment, so that the time consumption after superposition of the plurality of times of qubit measurement experiments is greatly reduced.

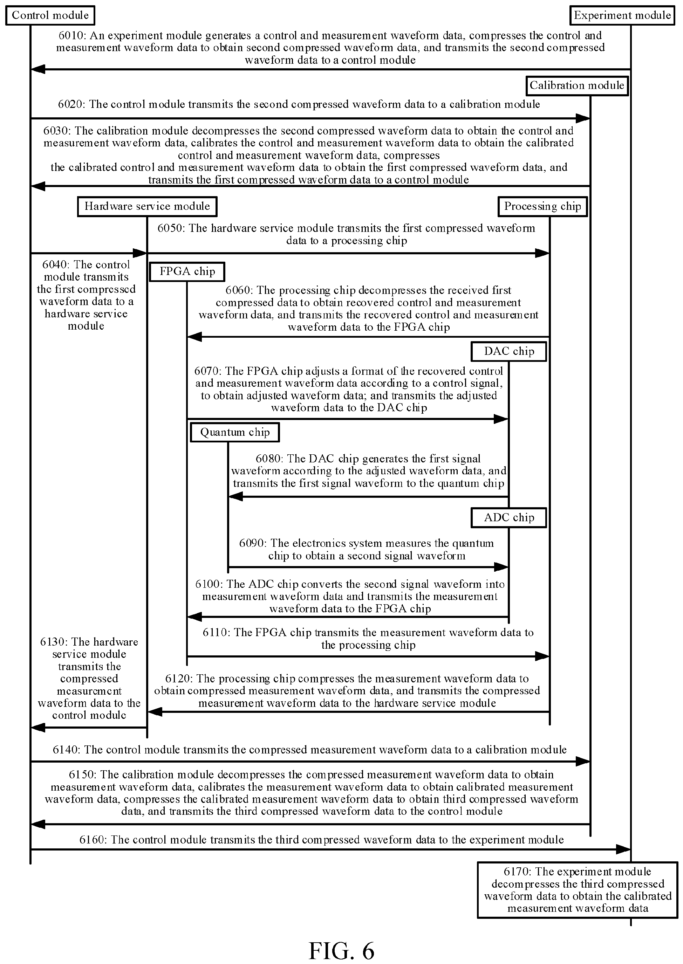

FIG. 6 is a flowchart of a waveform data transmission method according to an embodiment of this application. The method may be applied to a qubit control and measurement system. The method may include at least one of the following steps 6010 to 6170:
Step 6010: An experiment module generates a control and measurement waveform data, compresses the control and measurement waveform data to obtain second compressed waveform data, and transmits the second compressed waveform data to a control module.
Step 6020: The control module transmits the second compressed waveform data to a calibration module.
Step 6030: The calibration module decompresses the second compressed waveform data to obtain the control and measurement waveform data, calibrates the control and measurement waveform data to obtain the calibrated control and measurement waveform data, compresses the calibrated control and measurement waveform data to obtain the first compressed waveform data, and transmits the first compressed waveform data to a control module.
Step 6040: The control module transmits the first compressed waveform data to a hardware service module.
Step 6050: The hardware service module transmits the first compressed waveform data to a processing chip.

For an implementation of step 6010 to step 6050, related description of step 340 may be referred to, and details are not described herein again.

Step 6060: The processing chip decompresses the received first compressed data to obtain recovered control and measurement waveform data, and transmits the recovered control and measurement waveform data to the FPGA chip.

Step 6070: The FPGA chip adjusts a format of the recovered control and measurement waveform data according to a control signal, to obtain adjusted waveform data; and transmits the adjusted waveform data to a DAC chip.

Step 6080: The DAC chip generates the first signal waveform according to the adjusted waveform data, and transmits the first signal waveform to the quantum chip.

For an implementation of step 6060 to step 6080, related description of step 350 may be referred to, and details are not described herein again.

Step 6090: The electronics system measures the quantum chip to obtain a second signal waveform.

Step 6100: The ADC chip converts the second signal waveform into measurement waveform data and transmits the measurement waveform data to the FPGA chip, the measurement waveform data being data of the second signal waveform represented by a digital signal.

Step 6110: The FPGA chip transmits the measurement waveform data to the processing chip.

Step 6120: The processing chip compresses the measurement waveform data to obtain compressed measurement waveform data, and transmits the compressed measurement waveform data to the hardware service module.

Step 6130: The hardware service module transmits the compressed measurement waveform data to the control module.

Step 6140: The control module transmits the compressed measurement waveform data to a calibration module.

Step 6150: The calibration module decompresses the compressed measurement waveform data to obtain measurement waveform data, calibrates the measurement waveform data to obtain calibrated measurement waveform data, compresses the calibrated measurement waveform data to obtain third compressed waveform data, and transmits the third compressed waveform data to the control module.

Step 6160: The control module transmits the third compressed waveform data to the experiment module.

Step 6170: The experiment module decompresses the third compressed waveform data to obtain the calibrated measurement waveform data.

For an implementation of step 6090 to step 6170, related description of step 360 may be referred to, and details are not described herein again.

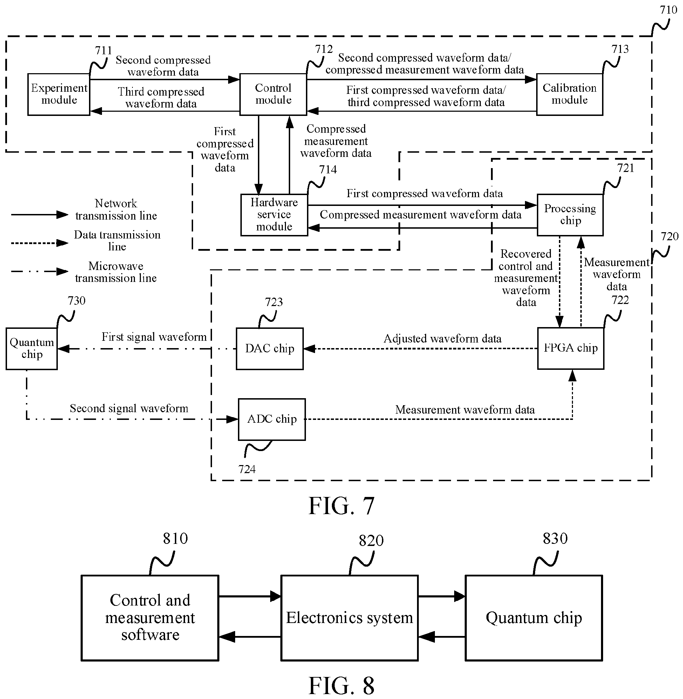

For example, as shown in FIG. 7, an experiment module 711 generates control and measurement waveform data, compresses the control and measurement waveform data to obtain second compressed waveform data, and transmits the second compressed waveform data to a control module 712. The control module 712 transmits the second compressed waveform data to the calibration module 713. The calibration module 713 decompresses the second compressed waveform data to obtain the control and measurement waveform data, calibrates the control and measurement waveform data to obtain the calibrated control and measurement waveform data, compresses the calibrated control and measurement waveform data to obtain the first compressed waveform data, and transmits the first compressed waveform data to the control module 712. The control module 712 transmits the first compressed waveform data to the hardware service module 714. The hardware service module 714 transmits the first compressed waveform data to a processing chip 721. The processing chip 721 decompresses the received first compressed data to obtain recovered control and measurement waveform data, and transmits the recovered control and measurement waveform data to an FPGA chip 722. The FPGA chip 722 adjusts a format of the recovered control and measurement waveform data according to a control signal, to obtain adjusted waveform data; and transmits the adjusted waveform data to a DAC chip 723. the DAC chip 723 generates the first signal waveform according to the adjusted waveform data, and transmits the first signal waveform to the quantum chip 730. Between the modules in the control and measurement software, and between the control and measurement software and the electronics system, information exchange is performed via a network transmission line.

The electronics system 720 measures the quantum chip to obtain a second signal waveform. The ADC chip 724 converts the second signal waveform into measurement waveform data, and transmits the measurement waveform data to the FPGA chip 722. The FPGA chip 722 transmits the measurement waveform data to the processing chip 721. The processing chip 721 compresses the measurement waveform data to obtain compressed measurement waveform data, and transmits the compressed measurement waveform data to the hardware service module 714. The hardware service module 714 transmits the compressed measurement waveform data to the control module 712. The control module 712 transmits the compressed measurement waveform data to the calibration module 713. The calibration module 713 decompresses the compressed measurement waveform data to obtain measurement waveform data, calibrates the measurement waveform data to obtain calibrated measurement waveform data, compresses the calibrated measurement waveform data to obtain third compressed waveform data, and transmits the third compressed waveform data to the control module 712. The control module 712 transmits the third compressed waveform data to the experiment module 711. The experiment module 711 decompresses the third compressed waveform data to obtain the calibrated measurement waveform data. Data exchange is carried out between chips in the electronics system by a digital signal transmission line (such as a data transmission line), and signal exchange is carried out between the electronics system and the quantum chip by a signal transmission line (such as a microwave transmission line) such as an analog signal transmission line.

According to the technical solution provided in the embodiments of this application, the control and measurement waveform data and the processing waveform data are compressed and transmitted, and the control and measurement waveform data and the measurement waveform data are calibrated, so that the accuracy of the qubit control and measurement experiment is ensured, the time consumption of the control and measurement waveform data and the measurement waveform data in the transmission process is reduced, and the overall time consumption of the qubit control and measurement experiment is reduced.

For the foregoing waveform transmission method of the qubit control and measurement system, experimental verification is carried out. After experimental testing, it is found that by using the waveform transmission method of the qubit control and measurement system of this application for two classical experiments commonly used in qubit measurement experiments: Ramsey and Randomized Benchmarking (RB), compared with the solution in the related art without any processing of waveform data, the experimental speed improvement effect is as follows:

**Table 1: Experimental speed test result**

| | Experiment time | Data transfer time | |
|---|---|---|---|
| | | Solution in the related art | Solution in this application |
| Ramsey experiment | ~250 ms | ~50 ms | <10 ms |
| RB experiment | ~280 ms | ~1500 ms | <10 ms |

Here, the total time of the qubit measurement experiment = the experiment time + the data transmission time.

It can be seen that because the waveform data is compressed in the data transmission process by using the waveform transmission method of the qubit control and measurement system of this application, the transmission time of the waveform data in the system is significantly compressed, thereby improving the overall qubit measurement experiment speed.

The following is a system embodiment of this application. For details not described in detail in the system embodiment, the foregoing method embodiment may be referred to.

FIG. 8 is a structural diagram of a qubit control and measurement system according to an embodiment of this application. The qubit control and measurement system has a function of implementing the foregoing method example. A qubit control and measurement system 800 includes: control and measurement software 810, an electronics system 820, and a quantum chip 830.

The control and measurement software 810 is configured to generate control and measurement waveform data, compress the control and measurement waveform data to obtain compressed data, and transmit the compressed data to the electronics system 820, the control and measurement waveform data being data of a first signal waveform represented by a digital signal for control and measurement of the quantum chip 830; and
the electronics system 820 is configured to decompress the received compressed data to obtain recovered control and measurement waveform data, and transmit the first signal waveform to the quantum chip 830 according to the recovered control and measurement waveform data, the first signal waveform being used for measuring and controlling the quantum chip 830.

In one embodiment, the control and measurement software 810 is configured to calibrate the control and measurement waveform data, to obtain the calibrated control and measurement waveform data; compress calibrated control and measurement waveform data to obtain first compressed waveform data; and transmit the first compressed waveform data to the electronics system 820.

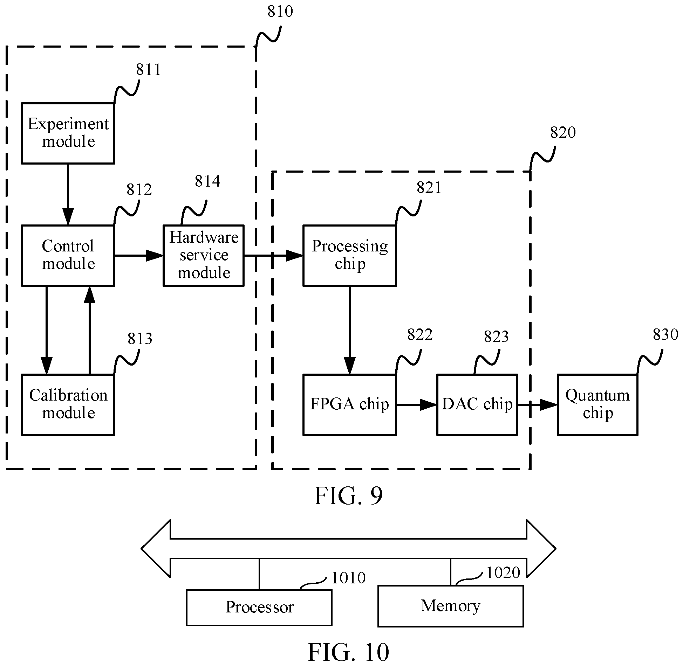

In one embodiment, as shown in FIG. 9, the control and measurement software 810 includes: an experiment module 811, a control module 812, a calibration module 813, and a hardware service module 814.

The experiment module 811 is configured to generate control and measurement waveform data, compress the control and measurement waveform data to obtain second compressed waveform data, and transmit the second compressed waveform data to the control module 812.

The control module 812 is configured to transmit the second compressed waveform data to the calibration module 813.

The calibration module 813 is configured to decompress the second compressed waveform data to obtain the control and measurement waveform data, calibrate the control and measurement waveform data to obtain the calibrated control and measurement waveform data, compress the calibrated control and measurement waveform data to obtain the first compressed waveform data, and transmit the first compressed waveform data to the control module 812.

The control module 812 is further configured to transmit the first compressed waveform data to the hardware service module 814.

The hardware service module 814 is configured to transmit the first compressed waveform data to the electronics system 820.

In one embodiment, the control and measurement software 810 is configured to obtain a calibration parameter of the control and measurement waveform data; and calibrate the control and measurement waveform data according to the calibration parameter, to obtain the calibrated control and measurement waveform data.

In one embodiment, the control and measurement software 810 is configured to transmit defined test waveform data to the electronics system 820;
the electronics system 820 is configured to generate a signal waveform corresponding to the test waveform data; and
the control and measurement software 810 is further configured to obtain actual waveform data obtained by measuring the signal waveform corresponding to the test waveform data, and determine the calibration parameter according to the test waveform data and the actual waveform data.

In one embodiment, as shown in FIG. 9, the electronics system 820 includes: a processing chip 821 and an FPGA chip 822.

The processing chip 821 is configured to decompress the received compressed data to obtain recovered control and measurement waveform data, and transmit the recovered control and measurement waveform data to the FPGA chip 822.

The FPGA chip 822 is configured to control a DAC chip 823 to generate a first signal waveform corresponding to the recovered control and measurement waveform data, and transmit the first signal waveform to the quantum chip 830.

In one embodiment, the FPGA chip 822 is configured to adjust a format of the recovered control and measurement waveform data according to a control signal, to obtain adjusted waveform data; and transmit the adjusted waveform data to a DAC chip 823, the DAC chip 823 being configured to generate the first signal waveform according to the adjusted waveform data, and transmit the first signal waveform to the quantum chip.

In one embodiment, the electronics system 820 is further configured to measure the quantum chip 830, to obtain the second signal waveform, and convert the second signal waveform into measurement waveform data, the measurement waveform data being data of the second signal waveform represented by a digital signal; and the electronics system 820 is further configured to compress the measurement waveform data and transmit the measurement waveform data to the control and measurement software 810.

According to the technical solution provided in this embodiment of this application, the control and measurement waveform data is compressed and transmitted, thereby reducing the time consumption of control and measurement waveform data in the transmission process. In the process of standardization and calibration of a qubit, usually a plurality of times of qubit measurement experiments need to be performed, and one qubit needs to be measured 1K to 10K (thousand) times in each a qubit measurement experiment, so that the time consumption after superposition of the plurality of times of qubit measurement experiments is greatly reduced.

Besides, an effective calibration parameter is obtained by calibrating the control and measurement waveform data and the measurement waveform data, thereby ensuring the accuracy of the qubit control and measurement experiment; and in addition, both the control and measurement waveform data and the measurement waveform data are transmitted in a compressed form, thereby reducing the time consumption of the control and measurement waveform data and the measurement waveform data in the transmission process.

FIG. 10 is a structural block diagram of a computer device according to an embodiment of this application.

The computer device in this embodiment of this application may include one or more of the following components: a processor 1010 and a memory 1020.

The processor 1010 may include one or more processing cores. The processor 1010 connects various parts of the entire computer device by using various interfaces and lines, and performs various functions of the computer device and processes data by running or executing instructions, programs, code sets, or instruction sets stored in the memory 1020, and calling data stored in the memory 1020. In one embodiment, the processor 1010 may be implemented in at least one form of hardware in digital signal processing (DSP), field programmable gate array (FPGA), and programmable logic array (PLA). The processor 1010 may be integrated into a central processing unit (CPU), a modem, or the like, or a combination thereof. The CPU mainly processes an operating system and an application program; the modem is configured to process wireless communications. It may be understood that the modem may not be integrated into the processor 1010, and may be implemented by using a single chip.

In one embodiment, in a case that the processor 1010 executes the program instructions in the memory 1020, the method provided in the foregoing method embodiments is implemented.

The memory 1020 may include a random access memory (RAM) or may include a read-only memory (ROM). In one embodiment, the memory 1020 includes a non-transitory computer-readable medium. The memory 1020 may be configured to store instructions, programs, codes, sets of codes, or sets of instructions. The memory 1020 may include a program storage area and a data storage area. The program storage area may store instructions for implementing the operating system, instructions for at least one function, instructions for implementing the foregoing method embodiments, and so on; the data storage area may store data or the like created according to the use of the computer device.

The structure of the above computer device is only schematic, and in an actual implementation, the computer device may include more or fewer components, such as: a display screen. This is not limited in this embodiment.

A person skilled in the art may understand that the structure shown in FIG. 10 constitutes no limitation on the computer device, and the computer device may include more or fewer components than those shown in the figure, or some components may be combined, or a different component deployment may be used.

In an exemplary embodiment, a computer-readable storage medium is further provided. The computer-readable storage medium stores a computer program, and the computer program may be executed by a processor to implement the foregoing waveform data transmission method.

In an exemplary embodiment, a computer program product is further provided. The computer program product includes a computer program, the computer program is stored in a computer-readable storage medium, and a processor reads and executes the computer program from the computer-readable storage medium, so as to implement the foregoing waveform data transmission method.

In an exemplary embodiment, a computer program is further provided. The computer program includes computer instructions, and the computer instructions are loaded and executed by a processor, so that the computer implements the foregoing waveform data transmission method.

"Plurality of" mentioned in the specification means two or more. "And/or" describes an association relationship for describing associated objects and represents that three relationships may exist. For example, A and/or B may represent the following three cases: Only A exists, both A and B exist, and only B exists. The character "/" in this specification generally indicates an "or" relationship between the associated objects. In addition, the step numbers described in this specification merely exemplarily show a possible execution sequence of the steps. In some other embodiments, the steps may not be performed according to the number sequence. For example, two steps with different numbers may be performed simultaneously, or two steps with different numbers may be performed according to a sequence contrary to the sequence shown in the figure. This is not limited in the embodiments of this application.

The foregoing descriptions are merely exemplary embodiments of this application, but are not intended to limit this application. Any modification, equivalent replacement, or improvement made within the spirit and principle of this application shall fall within the protection scope of this application.

## Claims

1. A waveform data transmission method, performed by a qubit control and measurement system, and the qubit control and measurement system comprising: control and measurement software, an electronics system, and a quantum chip; and the method comprising:
generating, by the control and measurement software, control and measurement waveform data, the control and measurement waveform data being data of a first signal waveform for control and measurement of the quantum chip, the first signal waveform being represented by a digital signal;
compressing, by the control and measurement software, the control and measurement waveform data to obtain compressed data, and transmitting, by the control and measurement software, the compressed data to the electronics system; and
decompressing, by the electronics system, the received compressed data to obtain recovered control and measurement waveform data, and transmitting, by the electronics system, the first signal waveform to the quantum chip according to the recovered control and measurement waveform data.

2. The method according to claim 1, wherein the compressing, by the control and measurement software, the control and measurement waveform data to obtain compressed data, and transmitting, by the electronics system, the compressed data to the electronics system comprises:
calibrating, by the control and measurement software, the control and measurement waveform data to obtain calibrated control and measurement waveform data;
compressing, by the control and measurement software, the calibrated control and measurement waveform data to obtain first compressed waveform data; and
transmitting, by the control and measurement software, the first compressed waveform data to the electronics system.

3. The method according to claim 1 or 2, wherein the control and measurement software comprises: an experiment module, a control module, a calibration module, and a hardware service module;
the experiment module is configured to generate the control and measurement waveform data, compress the control and measurement waveform data to obtain second compressed waveform data, and transmit the second compressed waveform data to the control module;
the control module is configured to transmit the second compressed waveform data to the calibration module;
the calibration module is configured to decompress the second compressed waveform data to obtain the control and measurement waveform data, calibrate the control and measurement waveform data to obtain calibrated control and measurement waveform data, compress the calibrated control and measurement waveform data to obtain the first compressed waveform data, and transmit the first compressed waveform data to the control module;
the control module is configured to transmit the first compressed waveform data to the hardware service module; and
the hardware service module is configured to transmit the first compressed waveform data to the electronics system.

4. The method according to claim 2, wherein the calibrating, by the control and measurement software, the control and measurement waveform data to obtain calibrated control and measurement waveform data comprises:
obtaining, by the control and measurement software, a calibration parameter of the control and measurement waveform data; and
calibrating, by the control and measurement software, the control and measurement waveform data according to the calibration parameter, to obtain the calibrated control and measurement waveform data.

5. The method according to claim 4, wherein the obtaining, by the control and measurement software, a calibration parameter of the control and measurement waveform data comprises:
transmitting, by the control and measurement software, defined test waveform data to the electronics system;
generating, by the electronics system, a signal waveform corresponding to the test waveform data; and
obtaining, by the control and measurement software, actual waveform data obtained by measuring the signal waveform corresponding to the test waveform data, and determining the calibration parameter according to the test waveform data and the actual waveform data.

6. The method according to any one of claims 1 to 5, wherein the electronics system comprises: a processing chip and a field programmable gate array, FPGA, chip; and
the decompressing, by the electronics system, the received compressed data to obtain recovered control and measurement waveform data, and transmitting, by the electronics system, the first signal waveform to the quantum chip according to the recovered control and measurement waveform data comprises:
decompressing, by the processing chip, the received compressed data to obtain recovered control and measurement waveform data, and transmitting, by the processing chip, the recovered control and measurement waveform data to the FPGA chip; and
controlling, by the FPGA chip, a digital to analog converter, DAC, chip to generate the first signal waveform corresponding to the recovered control and measurement waveform data, and transmitting, by the FPGA chip, the first signal waveform to the quantum chip.

7. The method according to claim 6, wherein the controlling, by the FPGA chip, a DAC chip to generate the first signal waveform corresponding to the recovered control and measurement waveform data, and transmitting, by the FPGA chip, the first signal waveform to the quantum chip comprise:
adjusting, by the FPGA chip, a format of the recovered control and measurement waveform data according to a control signal, to obtain adjusted waveform data;
transmitting, by the FPGA chip, the adjusted waveform data to the DAC chip; and
generating, by the DAC chip, the first signal waveform according to the adjusted waveform data, and transmitting, by the DAC chip, the first signal waveform to the quantum chip.

8. The method according to any one of claims 1 to 7, wherein the method further comprises:
measuring, by the electronics system, the quantum chip, to obtain a second signal waveform, and converting, by the electronics system, the second signal waveform into measurement waveform data, the measurement waveform data being data of the second signal waveform represented by a digital signal;
compressing, by the electronics system, the measurement waveform data and transmitting, by the electronics system, the compressed measurement waveform data to the control and measurement software.

9. A qubit control and measurement system, comprising: control and measurement software, an electronics system, and a quantum chip; and
the control and measurement software being configured to generate control and measurement waveform data, compress the control and measurement waveform data to obtain compressed data, and transmit the compressed data to the electronics system, the control and measurement waveform data being data of a first signal waveform for control and measurement of the quantum chip, the first signal waveform being represented by a digital signal; and
the electronics system being configured to decompress the received compressed data to obtain recovered control and measurement waveform data, and transmit the first signal waveform to the quantum chip according to the recovered control and measurement waveform data, the first signal waveform being used for measuring and controlling the quantum chip.

10. The qubit control and measurement system according to claim 9, wherein
the control and measurement software is configured to: calibrate the control and measurement waveform data to obtain calibrated control and measurement waveform data; compress the calibrated control and measurement waveform data to obtain first compressed waveform data; and transmit the first compressed waveform data to the electronics system.

11. The qubit control and measurement system according to claim 9 or 10, wherein the control and measurement software comprises: an experiment module, a control module, a calibration module, and a hardware service module;
the experiment module is configured to generate the control and measurement waveform data, compress the control and measurement waveform data to obtain second compressed waveform data, and transmit the second compressed waveform data to the control module;
the control module is configured to transmit the second compressed waveform data to the calibration module;
the calibration module is configured to decompress the second compressed waveform data to obtain the control and measurement waveform data, calibrate the control and measurement waveform data to obtain calibrated control and measurement waveform data, compress the calibrated control and measurement waveform data to obtain the first compressed waveform data, and transmit the first compressed waveform data to the control module;
the control module is further configured to transmit the first compressed waveform data to the hardware service module; and
the hardware service module is configured to transmit the first compressed waveform data to the electronics system.

12. The qubit control and measurement system according to claim 10, wherein
the control and measurement software is configured to: obtain a calibration parameter of the control and measurement waveform data; and calibrate the control and measurement waveform data according to the calibration parameter, to obtain the calibrated control and measurement waveform data.

13. The qubit control and measurement system according to claim 12, wherein
the control and measurement software is configured to transmit defined test waveform data to the electronics system;
the electronics system is configured to generate a signal waveform corresponding to the test waveform data; and
the control and measurement software is further configured to obtain actual waveform data obtained by measuring the signal waveform corresponding to the test waveform data, and determine the calibration parameter according to the test waveform data and the actual waveform data.

14. The qubit control and measurement system according to any one of claims 9 to 13, wherein the electronics system comprises: a processing chip and a field programmable gate array, FPGA, chip; and
the processing chip is configured to decompress the received compressed data to obtain recovered control and measurement waveform data, and transmit the recovered control and measurement waveform data to the FPGA chip; and
the FPGA chip is configured to control a digital to analog converter, DAC, chip to generate the first signal waveform corresponding to the recovered control and measurement waveform data, and transmit the first signal waveform to the quantum chip.

15. The qubit control and measurement system according to claim 14, wherein
the FPGA chip is configured to adjust a format of the recovered control and measurement waveform data according to a control signal, to obtain adjusted waveform data; and transmit the adjusted waveform data to the DAC chip, wherein the DAC chip is configured to generate the first signal waveform according to the adjusted waveform data, and transmit the first signal waveform to the quantum chip.

16. The qubit control and measurement system according to any one of claims 9 to 15, wherein
the electronics system is further configured to measure the quantum chip, to obtain a second signal waveform, and convert the second signal waveform into measurement waveform data, the measurement waveform data being data of the second signal waveform represented by a digital signal; and
the electronics system is configured to compress the measurement waveform data and transmitting the compressed measurement waveform data to the control and measurement software.

17. A computer device, comprising a processor and a memory, storing a computer program, and the computer program being loaded and executed by the processor to implement the waveform data transmission method according to any one of claims 1 to 8.

18. A non-volatile computer-readable storage medium, storing a computer program, and the computer program being loaded and executed by a processor to implement the waveform data transmission method according to any one of claims 1 to 8.

19. A computer program product, comprising a computer program, the computer program being stored in a computer-readable storage medium, and a processor reading and executing the computer program from the computer-readable storage medium, so as to implement the waveform data transmission method according to any one of claims 1 to 8.

20. A computer program, comprising computer instructions, and the computer instructions being loaded and executed by a processor, so that the computer implements the waveform data transmission method according to any one of claims 1 to 8.
